# EUROPÄISCHE PATENTSCHRIFT

(11) **EP 1 205 969 B1**
(45) Veröffentlichungstag und Bekanntmachung des Hinweises auf die Patenterteilung: **25.02.2009**
(21) Anmeldenummer: 01125066.9
(22) Anmeldetag: 22.10.2001
(51) Int. Cl.: H01L 21/336, H01L 29/78

(54) **Verfahren zur Herstellung eines MOS-Feldeffekt-Transistors mit Rekombinationszone**
Method of manufacturing a MOS field effect transistor with a recombination zone
Procédé de fabrication d'un transistor à effet de champ MOS avec une zone de recombinaison

(30) Priorität: 10.11.2000 DE 10055765
(43) Veröffentlichungstag der Anmeldung: 15.05.2002
(73) Patentinhaber: Infineon Technologies AG, 81669 München (DE)
(72) Erfinder: Kröner, Friedrich, 9500 Villach (AT)
(74) Vertreter: Kindermann, Peter

(56) Entgegenhaltungen:
- DE-A1- 19 732 912
- DE-A1- 19 743 265
- US-A- 4 620 211
- US-A- 5 382 818
- US-A- 5 708 286
- "DEFECT-FREE SI IN REGROWN SIMOX STRUCTURES" IBM TECHNICAL DISCLOSURE BULLETIN, IBM CORP. NEW YORK, US, Bd. 35, Nr. 3, 1. August 1992 (1992-08-01), Seiten 60-61, XP000326169 ISSN: 0018-8689
- PATENT ABSTRACTS OF JAPAN Bd. 012, Nr. 449 (E-686), 25. November 1988 (1988-11-25) & JP 63 177473 A (NISSAN MOTOR CO LTD), 21. Juli 1988 (1988-07-21)

## Beschreibung

Die Erfindung betrifft ein Verfahren mit einer robusten Prozeßfolge zur Herstellung eines MOS-Feldeffekt-Transistors mit Rekombinationszone, und bezieht sich insbesondere auf ein Verfahren zur Herstellung eines MOS-Feldeffekt-Transistors mit einem horizontalen vergrabenen, aus Polysilizium bestehenden Gate und einer oberflächenseitig angeordneten Rekombinationszone.

Ein bekannter n-Kanal-MOS-Leistungstransistor weist einen aus der Source-Region als Emitter, dem Kanal bzw. der sogenannten "p-Body"-Region als dem die Kanalzone bildenden Teil der einzelnen Silizium-Inseln in der Isolatorschicht als Basis und dem Substrat als Kollektor bestehenden parasitären Bipolartransistor auf. Tritt nun bei einem solchen Transistor an dessen Drain-Anschluß eine negativere Spannung als an dem Source-Anschluß auf, so kann dieser üblicherweise den Stromfluß nicht sperren, da zur Verhinderung eines verfrühten Durchbruchs des parasitären Transistors in der Struktur Source-Region und p-Body-Region kurzgeschlossen sind.

Falls der pn-Übergang zwischen Source-Region und p-Body-Region dennoch sperrfähig sein soll, muß daher der verfrühte Durchbruch des parasitären Bipolartransistors mit anderen Mitteln verhindert werden.

Zu diesem Zweck wurde bisher entweder eine zusätzliche Diode in Serie geschaltet, welches in nachteiliger Weise einen zusätzlichen unerwünschten Spannungsabfall in dem Schaltkreis zur Folge hat, oder wurden Freilaufdioden angeordnet und entsprechend deren Dimensionierung ein kontrollierter Stromfluß durch den Leistungstransistor billigend in Kauf genommen.

Neuere Entwicklungen zielen nun darauf ab, in die p-Body-Region eine Rekombinationszone einzubringen, mittels der der Basisstrom des parasitären Bipolartransistors so unterdrückbar ist, daß bei diesem kein verfrühter Durchbruch ausgelöst wird. Hierbei wurde zunächst vorgeschlagen, die Geometrie der beteiligten Transistoren im Wesentlichen beizubehalten und zusätzlich ein Metall in die p-Body-Region einzubringen. Als hierbei nachteilig erwiesen sich komplizierte, wenig tolerante Prozeßabläufe mit hohen Anforderungen an die Präzision der Einzelprozesse, sowie Probleme aufgrund von Wechselwirkungen zwischen dem eingebrachten Metall und vorhandenem Silizium.

Aus der US 5,708,286 sind eine Halbleitervorrichtung mit isoliertem Gate sowie ein Herstellungsverfahren derselben bekannt. Ein Leistungstransistor hat eine erste Gateelektrode oberhalb eines Kanalbereiches und eine zweite Gateelektrode unterhalb eines Kanalbereichs. Aus der US 5,392,818 ist eine laterale SOI Halbleitervorrichtung mit einer vergrabenen Diode bekannt. Aus dem Artikel "Defect-free Si in regrow SIMOX structures", IBM Technical Disclosure Bulletin, IBM Corp. New York, US, Bd. 35, Nr. 3, August 1992, Seiten 60 und 61, ist ein Verfahren zum Herstellen von SOI-Wafern bekannt. Aus der DE 197 43 265 A1 ist ein Halbleiterbauelement mit erhöhter Latch-up-Festigkeit bekannt. Eine Ladungsträger-Rekombinationszone aus Metall oder polykristallinem Silizium ist in Silizium eingebettet.

Aus der JP 63177473 ist ein vertikaler MOSFET bekannt, der innerhalb eines Basisbereichs einen polykristallinen Halbleiterbereich enthält, um das Einschalten eines parasitären Bipolartransistors zu erschweren. Aus der US 4,620,211 ist ein IGT (Insulated-Gate Transistor) bzw. IGFET bekannt, der implantierte Bereiche enthält, welche Defekte erzeugen, die Rekombinationszentren bilden.

Der Erfindung liegt daher die Aufgabe zugrunde, ein robustes Verfahren zur Herstellung eines eine Rekombinationszone aufweisenden MOS-Feldeffekt-Transistors bereitzustellen, mit dem auf Wechselwirkungen zwischen Metall und Silizium zurückzuführende Probleme vermeidbar sind.

Diese Aufgabe wird durch die in Patentanspruch 1 angegebenen Merkmale gelöst.

Alternativ wird diese Aufgabe durch die in Patentanspruch 5 angegebenen Merkmale gelöst.

Erfindungsgemäß wird somit ein Verfahren vorgeschlagen, bei dem zunächst sämtliche Hochtemperatur erfordernde Schritte zur Herstellung von etwa Dotierungen, Gateoxiden, Isolierungen und aus Polysilizium bestehenden Gatebereichen durchgeführt werden und erst dann ein der Rekombination dienendes Metall mit der p-Body-Region in Kontakt gebracht wird, wodurch eine Umkehrung der Anordnung des aus Polysilizium bestehenden Gates und der Rekombinationszone erzielt wird und dadurch nachteilige Wechselwirkungen zwischen dem eingebrachten Metall und dem vorhandenen Silizium vermieden werden.

Bevorzugt wird als Ausgangsmaterial Wafer-gebondetes SOI-Material verwendet.

Besondere Vorteile ergeben sich, wenn die vergrabene Oxidschicht durch Implantation von Sauerstoff hergestellt wird.

Erfolgt insbesondere eine solche Implantation von Sauerstoff strukturiert, können die Schritte des Strukturierens eines Ausgangsmaterials mit einer vergrabenen Oxidschicht und einer dünnen aktiven Siliziumschicht sowie des epitaxialen Abscheidens von Silizium auf das strukturierte Ausgangsmaterial und außerhalb desselben entfallen, wodurch sich eine vorteilhafte Vereinfachung und Verkürzung der Prozeßdauer ergibt.

Die Erfindung wird nachstehend anhand von Ausführungsbeispielen unter Bezugnahme auf die Zeichnung näher beschrieben.

Es zeigen:
Fig. 1a) bis 1e) vereinfacht und aufeinanderfolgend eine Prozeßfolge zur Herstellung eines MOS-Feldeffekt-Transistors gemäß einem Ausführungsbeispiel des Verfahrens bis zur Ausbildung eines in einem Silizium-Substrat vergrabenen Polysilizium-Gates; und
Fig. 2a) und 2b) vereinfacht und ausschnittsweise die Geometrie der Source-Region, der Rekombinationszone und des Sourcesowie des Gate-Anschlusses in der nach Fig. 1 erzeugten Struktur.

Nachstehend wird eine Gesamtprozeßfolge zur Herstellung eines MOS-Feldeffekt-Transistors gemäß einem bevorzugten ersten Ausführungsbeispiel des Verfahrens beschrieben.

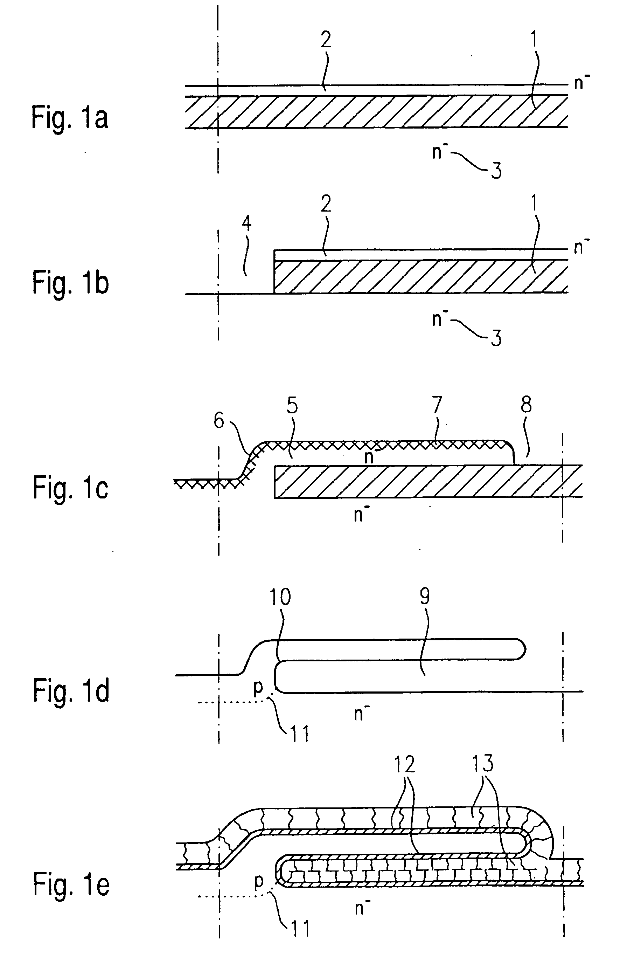

Fig. 1a) bis 1e) zeigen vereinfacht und aufeinanderfolgend eine Prozeßfolge zur Herstellung eines MOS-Feldeffekt-Transistors bis zur Ausbildung eines in einem Silizium-Substrat vergrabenen Polysilizium-Gates.

Im Einzelnen wird nach Fig. 1a) als Ausgangsmaterial ein der Spannungsklasse des aufzubauenden MOS-Feldeffekt-Transistors entsprechendes n-Material 3 mit einer vergrabenen Oxidschicht 1 verwendet.

Ein geeignetes Ausgangsmaterial ist beispielsweise ein Silicon-On-Isolator- bzw. SOI-Wafer, d. h. eine Verbundstruktur bestehend aus einer aktiven Schicht 2 von Silizium, die auf einem isolierenden Material, hier dem n-Material 3 mit der vergrabenen Oxidschicht 1, abgeschieden ist.

Die Schicht aktiven Siliziums 2 oberhalb der vergrabenen Oxidschicht 1 muß hierbei in Übereinstimmung mit der zu erzielenden Wirkung einer Rekombinationszone entsprechend dem geringen Abstand zwischen Metall und Kanal sehr dünn sein.

SOI-Wafer mit hinreichend dünner aktiver Siliziumschicht lassen sich beispielsweise sowohl mittels dem sogenannten SMART-CUT-Verfahren als auch durch Implantation von Sauerstoff herstellen, wobei vorzugsweise das SMART-CUT-Verfahren zur Anwendung kommt, da bei diesem größere Freiheiten in der Wahl der vergrabenen Oxidschicht 1 möglich sind. Solche Ausgangsmaterialien sind käuflich erwerbbar.

In einem ersten Schritt eines ersten Prozeßblocks des Gesamtprozesses werden gemäß Fig. 1b) zunächst die dünne Schicht 2 aktiven Siliziums und die vergrabene Oxidschicht 1 derart strukturiert, daß in einem Abschnitt 4 nahe der späteren Source-Region das n-Material 3 freigelegt wird.

In einem zweiten Schritt werden gemäß Fig. 1c) sodann eine n-Epitaxieschicht 5 von Silizium abgeschieden, danach maskenlos eine p-Schicht 7 implantiert, und anschließend durch Freilegen bzw. Öffnen von Teilbereichen der vergrabenen Oxidschicht 1 Ätzkanäle 8 zur späteren Herstellung von aus Polysilizium bestehenden Gate-Regionen konventionell definiert. Die geometrische Form der Kante 6 der Epitaxieschicht 5 ist durch geeignete Wahl der Prozeßparameter beeinflußbar.

Wie in Fig. 1d) gezeigt, wird nachfolgend in einem in Bezug auf den Gesamtprozeß als solchen vollkommen unkritischen dritten Schritt das gesamte Siliziumoxid mittels einer Flußsäurelösung (HF) geätzt und dadurch so entfernt, daß sich Hohlräume 9 ausbilden, und werden mittels einer Opfer-Oxidation die Kanten und Ecken 10 der soweit erzeugten Struktur verrundet. Während dieser Opfer-Oxidation diffundiert Material aus der vorangehend implantierten p-Schicht 7 in Richtung des n-Materials 3 und bildet mit diesem den pn-Übergang 11 zwischen dem späteren Kanal und der Drain-Region.

Gemäß Fig. 1e) werden in einem letzten Schritt dieses ersten Prozeßblocks eine Gate-Oxidation 12 und eine Polysilizium-Abscheidung 13 durchgeführt, welche die vergrabenen Polysilizium-Gate-Regionen vervollständigen.

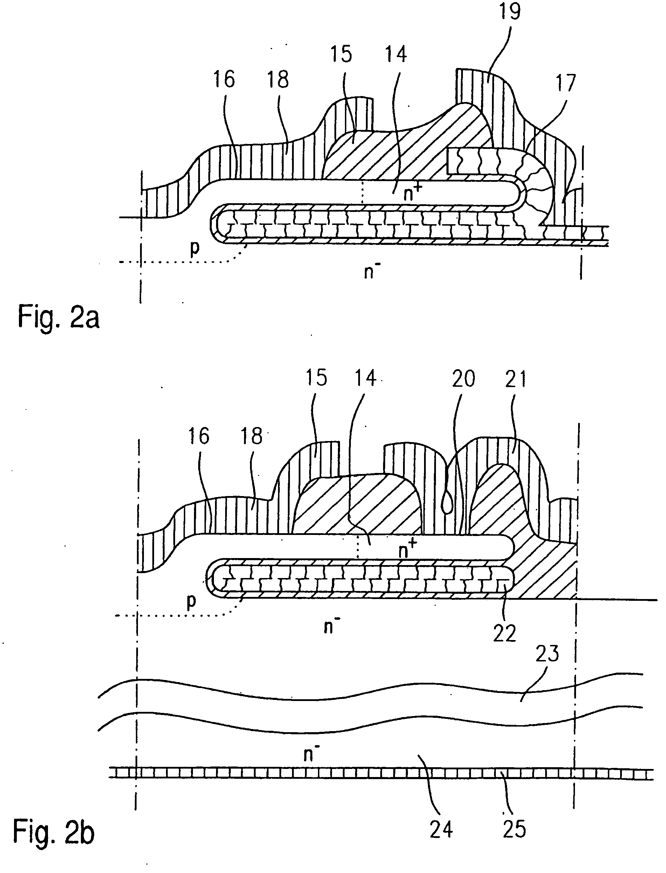

Bezugnehmend auf Fig. 2 wird nachstehend ein zweiter Prozeßblock des Gesamtprozesses des ersten Ausführungsbeispiels beschrieben.

Fig. 2a) zeigt vereinfacht und ausschnittsweise die Geometrie der Source-Region, der Rekombinationszone und des Source- sowie des Gate-Anschlusses in einer durch den ersten Prozeßblock nach Fig. 1 erzeugten Struktur, die durch Ätzen des abgeschiedenen Polysiliziums 13 unter Verwendung einer Lackmaske erhalten wird.

In einem ersten Schritt des zweiten Prozeßblocks wird zunächst ein n⁺-Material zur Herstellung der späteren Source-Regionen 14 strukturiert implantiert und diffundiert.

In einem zweiten Schritt wird sodann ein als Dielektrikum dienendes Zwischenoxid 15 abgeschieden und an Stellen entfernt, an welchen noch aufzubringendes Metall mit dem darunterliegenden Silizium in Kontakt stehen soll. Daher wird das Zwischenoxid 15 zur Erzeugung der Rekombinationszonen in einem Bereich 16 über dem Kanal und zur Erzeugung des Polysilizium-Anschlusses in einem Bereich 17 geöffnet.

Anschließend wird in einem dritten Schritt Metall für eine Rekombinationszone 18 und einen Gate-Kontakt 19 strukturiert aufgebracht.

Fig. 2b) zeigt vereinfacht und ausschnittsweise die Geometrie der Source-Region, der Rekombinationszone und des Source- sowie des Gate-Anschlusses in einer durch den ersten Prozeßblock nach Fig. 1 erzeugten Struktur, die durch Ätzen des abgeschiedenen Polysiliziums 13 ohne Verwendung einer Lackmaske derart erhalten wird, daß durch den Ätzvorgang des Polysiliziums 13 der Polysilizium-Bereich 17 ebenfalls entfernt, woraus ein gegenüber der Struktur nach Fig. 1 unterschiedlicher Oberflächenverlauf der Zwischenschicht 15 in der Umgebung des Gate-Kontakts resultiert.

In diesem Fall wird in dem dritten Schritt über eine Öffnung 20 in dem Zwischenoxid 15 Metall für einen Source-Anschluß 21 strukturiert aufgebracht.

Das von dem Polysilizium 13 verbleibende Polysilizium 22 kann hierbei im Inneren der Struktur ohne Weiteres verbunden sein, und gegebenenfalls erforderliche Gate-Widerstände sind dann durch ein entsprechendes Layout des MOS-Feldeffekt-Transistors einstellbar.

In Abhängigkeit von der Spannungsklasse verbleibt bei den vorstehend beschriebenen Strukturen auf der rückwärtigen Seite des MOS-Feldeffekt-Transistors in nicht maßstäblich dargestellter Dicke Ausgangsmaterial 23 bis hin zu einer Drain-Region 24 mit einer üblichen Metallisierung 25 auf der Rückseite des Wafers.

In einer alternativen Ausführungsform kann in dem vorstehend beschriebenen ersten Schritt des ersten Prozeßblocks eine Implantation von Sauerstoff strukturiert erfolgen und hierdurch die Schritte des Strukturierens eines Ausgangsmaterials mit einer vergrabenen Oxidschicht und einer dünnen aktiven Siliziumschicht sowie des epitaxialen Abscheidens von Silizium auf das strukturierte Ausgangsmaterial und außerhalb desselben entfallen, wodurch sich eine vorteilhafte Vereinfachung und Verkürzung der Prozeßdauer ergibt.

Wie vorstehend beschrieben wurde, werden somit zunächst sämtliche Hochtemperatur erfordernde Schritte zur Herstellung von etwa Dotierungen, Gateoxiden, Isolierungen und aus Polysilizium bestehenden Gate-Regionen durchgeführt und erst dann der Rekombination dienendes Metall derart mit der p-Body-Region in Kontakt gebracht, daß der kritische Abstand zwischen dem Kanal und dem Metall durch gut kontrollierbare Schichtdicken aus epitaxialer Abscheidung von Silizium einstellbar ist, die Sperrfähigkeit der pn-Übergänge durch bisher übliche Oberflächen- und Strukturierungsverfahren sichergestellt wird und kontrollierbar ist, weitgehende Wahlfreiheit bezüglich der Auswahl des der Rekombination dienenden Metalls besteht, und robuste Einzelprozesse mit kostengünstigem Gerät älterer Generation anwendbar sind.

Die Prozeßfolge des beschriebenen Verfahrens zur Herstellung eines MOS-Feldeffekt-Transistors mit Rekombinationszone umfaßt somit die Herstellung eines MOS-Leistungstransistors mit horizontalem Polysilizium-Gate derart, daß zunächst das horizontale Polysilizium-Gate erzeugt und erst danach die Rekombinationszone eingebracht wird, so daß sich hieraus resultierend in Aufbaurichtung des Transistors das Gate "unten", das Kanalgebiet "in der Mitte" und die Rekombinationszone "oben" befinden.

Durch diese Umkehrung der Anordnung der einzelnen Komponenten eines solchen Transistors ist es möglich, mit robusten Einzelprozessen älterer Generation, beispielsweise zumindest der zweitältesten Generation, einen Transistor mit einer Rekombinationszone herzustellen, ohne von den durch die geringe Hochtemperaturverträglichkeit von Metallen verursachten Problemen, d. h. ohne beispielsweise Diffusion, Spiking und Bildung von Eutektika, betroffen zu sein und dennoch mit gut kontrollierbaren horizontalen Strukturen zu arbeiten.

## Patentansprüche

1. Verfahren, bei dem ein MOS-Feldeffekt-Transistor hergestellt wird, mit einem horizontalen vergrabenen, aus Polysilizium bestehenden Gate (22) und einer oberflächenseitig angeordneten Rekombinationszone (16), mit den in der folgenden Reihenfolge ausgeführten Schritten des:
- Strukturierens eines Ausgangsmaterials, das Ausgangsmaterial besteht aus n-Material (3), einer vergrabenen Oxidschicht (1) und einer dünnen aktiven Siliziumschicht (2), wobei die dünne Schicht (2) aktiven Siliziums und die vergrabene Oxidschicht (1) derart strukturiert werden, daß in einem Abschnitt (4) nahe der späteren Source-Region das n-Material (3) freigelegt wird;
- epitaxialen Abscheidens von Silizium (5) auf das strukturierte Ausgangsmaterial (1, 2, 3), nämlich auf das freigelegte n-Material und auf die strukturierte dünne aktive Siliziumschicht (2);
- Gegendotierens eines p-Body-Bereiches enthaltend einen Kanalbereich;
- Freilegens von Teilbereichen (8) der vergrabenen Oxidschicht (1);
- Ätzens zur Entfernung (9) jeglichen Siliziumoxids;
- Ausbildens eines Gateoxids (12) und eines Polysilizium-Gates (13);
- Strukturierens des Polysiliziums (13);
- strukturierten Herstellens von Source-Dotierungen (14);
- strukturierten Herstellens eines Dielektrikums (15);
- Strukturierens eines der Rekombination dienenden Metalls (18), das mit dem darunter liegenden Silizium des p-Body-Bereichs in einem Bereich (16) über dem Kanalbereich in Kontakt gebracht wird, nachdem sämtliche Hochtemperatur erfordernde Schritte zur Herstellung von Dotierungen, Gateoxiden, Isolierungen und aus Polysilizium bestehenden Gatebereichen durchgeführt worden sind; und
- Herstellens von Gate- und Sourcekontakten (19, 21).

2. Verfahren nach Anspruch 1, **dadurch gekenzeichnet, daß** als Ausgangsmaterial (1, 2, 3) wafer-gebondetes SOI-Material verwendet wird.

3. Verfahren nach Anspruch 1, **dadurch gekennzeichnet, daß** die vergrabene Oxidschicht (1) durch Implantation von Sauerstoff hergestellt wird.

4. Verfahren nach Anspruch 3, **dadurch gekennzeichnet, daß** die Implantation von Sauerstoff strukturiert erfolgt.

5. Verfahren, bei dem ein MOS-Feldeffekt-Transistor hergestellt wird, mit einem horizontalen vergrabenen, aus Polysilizium bestehenden Gate (22) und einer oberflächenseitig angeordneten Rekombinationszone (16), mit den in der folgenden Reihenfolge ausgeführten Schritten des:
- strukturierten Implantierens von Sauerstoff in ein Ausgangsmaterial (3);
- Gegendotierens eines p-Body-Berei-ches enthaltend einen Kanalbereich;
- Freilegens von Teilbereichen (8) der vergrabenen Oxidschicht (1);
- Ätzens zur Entfernung (9) jeglichen Siliziumoxids;
- Ausbildens eines Gateoxids (12) und eines Polysilizium-Gates (13);
- Strukturierens des Polysiliziums (13);
- strukturierten Herstellens von Source-Dotierungen (14);
- strukturierten Herstellens eines Dielektrikums (15);
- Strukturierens eines der Rekombination dienenden Metalls (18), das mit dem darunter liegenden Silizium des p-Bodybereichs in einem Bereich (16) über dem kanalbereich in Kontakt gebracht wird nachdem sämtliche Hochtemperatur erfordernde Schritte zur Herstellung von Dotierungen, Gateoxiden, Isolierungen und aus Polysilizium bestehenden Gatebereichen durchgeführt worden sind; und
- Herstellens von Gate- und Source-Kontakten (19, 21).

## Claims

1. Process in which an MOS field effect transistor is produced having a horizontal buried gate (22) consisting of polysilicon and a recombination zone (16) arranged at the surface, comprising the steps performed in the following order of:
- structuring a starting material, the starting material is composed of n-type material (3), a buried oxide layer (1) and a thin active silicon layer (2), the thin layer (2) of active silicon and the buried oxide layer (1) being structured in such a way that the n-type material (3) is exposed in a section (4) close to the subsequent source region;
- epitaxial deposition of silicon (5) onto the structured starting material (1, 2, 3), namely onto the exposed n-type material and onto the structured thin active silicon layer (2);
- opposite doping of a p-type body region comprising a channel region;
- exposing subareas (8) of the buried oxide layer (1) ;
- etching to remove (9) any silicon oxide;
- forming a gate oxide (12) and a polysilicon gate (13);
- structuring the polysilicon (13);
- structured production of source doping (14);
- structured production of a dielectric (15);
- structuring a metal (18) used for the recombination, which metal is brought into contact with the underlying silicon of the p-type body region in a region (16) above the channel region after all the steps requiring high temperature for the production of dopings, gate oxides, insulations and gate regions composed of polysilicon have been carried out; and
- producing gate and source contacts (19, 21).

2. Process according to Claim 1, **characterized in that** the starting material (1, 2, 3) used is wafer-bonded SOI material.

3. Process according to Claim 1, **characterized in that** the buried oxide layer (1) is produced by implantation of oxygen.

4. Process according to Claim 3, **characterized in that** the implantation of oxygen is carried out in a structured manner.

5. Process in which an MOS field effect transistor is produced, having a horizontal buried gate (22) consisting of polysilicon and a recombination zone (16) arranged at the surface, comprising the steps performed in the following order of:
- structured implantation of oxygen into a starting material (3);
- opposite doping of a p-type body region comprising a channel region;
- exposing subareas (8) of the buried oxide layer (1) ;
- etching to remove (9) any silicon oxide;
- forming a gate oxide (12) and a polysilicon gate (13);
- structuring the polysilicon (13);
- structured production of source doping (14);
- structured production of a dielectric (15);
- structuring a metal (18) used for the recombination, which metal is brought into contact with the underlying silicon of the p-type body region in a region (16) above the channel region after all the steps requiring high temperature for the production of dopings, gate oxides, insulations and gate regions composed of polysilicon have been carried out; and
- producing gate and source contacts (19, 21).

## Revendications

1. Procédé dans lequel on produit un transistor à effet de champ MOS comprenant une grille (22) horizontale enterrée en polysilicium et une zone (16) de recombinaison disposée du côté de la surface, comprenant les stades réalisés dans l'ordre suivant de :
- structuration d'une matière de départ, la matière de départ étant constituée de matière (3) n, d'une couche (1) d'oxyde enterrée et d'une mince couche (2) de silicium actif, la mince couche (2) de silicium actif et la couche (1) d'oxyde enterrée étant structurées de manière à mettre à nu la matière (3) n dans une partie (4) proche de la région de source ultérieure ;
- dépôt par épitaxie de silicium sur la matière (1, 2, 3) de départ structurée, à savoir sur la matière n mise à nu et sur la mince couche (2) de silicium actif structurée ;
- contre-dopage d'une zone de corps p contenant une zone de canal ;
- mise à nu de sous-zones de la couche d'oxyde enterrée ;
- attaque pour l'élimination (9) de tout oxyde de silicium ;
- constitution d'un oxyde (12) de grille et d'une grille (13) en polysilicium ;
- structuration du polysilicium (13) ;
- production structurée de dopage (14) de source ;
- production structurée d'un diélectrique (15) ;
- structuration d'un métal (18) servant à la recombinaison, qui est mis dans une zone (16) au-dessus de la zone de canal en contact avec le silicium sous-jacent de la zone de corps p, après que tous les stades exigeant une température haute pour la production de dopages d'oxyde de grille, d'isolants et de zones de grille en polysilicium ont été effectués ; et
- production de contacts (19, 21) de grille et de source.

2. Procédé suivant la revendication 1, **caractérisé en ce que** l'on utilise comme matière (1, 2, 3) de départ de la matière SOI liée par tranche.

3. Procédé suivant la revendication 1, **caractérisé en ce que** l'on produit la couche (1) d'oxyde enterrée par implantation d'oxygène.

4. Procédé suivant la revendication 3, **caractérisé en ce qu'**on effectue l'implantation d'oxygène de façon structurée.

5. Procédé dans lequel on produit un transistor à effet de champ MOS comprenant une grille (22) horizontale enterrée en polysilicium et une zone (16) de recombinaison disposées du côté de la surface comprenant les stades réalisés dans l'ordre suivant de :
- implantation structurée d'oxygène dans une matière (3) de départ ;
- contre-dopage d'une zone de corps p contenant une zone de canal ;
- mise à nu de sous-zones (8) de la couche (1) d'oxyde enterrée ;
- attaque pour l'élimination (9) de tout oxyde de silicium ;
- constitution d'un oxyde (12) de grille et d'une grille (13) en polysilicium ;
- structuration du polysilicium (13) ;
- production structurée de dopage (14) de source ;
- production structurée d'un diélectrique (15) ;
- structuration d'un métal (18) servant à la recombinaison, qui est mis dans une zone (16) au-dessus de la zone de canal en contact avec le silicium sous-jacent de la zone de corps, après que tous les stades exigeant une température haute pour la production de dopages d'oxyde de grille, d'isolants et de zones de grille en polysilicium ont été effectués ; et
- production de contacts (19, 21) de grille et de source.
